# EUROPEAN PATENT SPECIFICATION

(11) **EP 4 068 344 B1**
(45) Date of publication and mention of the grant of the patent: **14.08.2024**
(21) Application number: 22152695.7
(22) Date of filing: 21.01.2022
(51) Int. Cl.: H01L 21/768, H01L 23/528

(54) **SEMICONDUCTOR DEVICE**
HALBLEITERBAUELEMENT
DISPOSITIF SEMICONDUCTEUR

(30) Priority: 29.03.2021 KR 20210040360; 20.05.2021 KR 20210064641
(43) Date of publication of application: 05.10.2022
(73) Proprietor: Samsung Electronics Co., Ltd., Suwon-si, Gyeonggi-do 16677 (KR)
(72) Inventor: PARK, Jung Il, 16677 Suwon-si, Gyeonggi-do (KR); AHN, Jeong Hoon, 16677 Suwon-si, Gyeonggi-do (KR); CHOI, Yun Ki, 16677 Suwon-si, Gyeonggi-do (KR)
(74) Representative: Kuhnen & Wacker Patent- und Rechtsanwaltsbüro PartG mbB

(56) References cited:
- US-A1- 2019 013 236
- US-A1- 2020 083 094
- US-A1- 2020 335 348
- US-B1- 9 875 966

## Description

### BACKGROUND

### 1. Technical Field

Embodiments of the present disclosure are directed to a semiconductor device and more particularly, to a semiconductor device that includes a wiring line formed in a back-end-of-line (BEOL) process.

### 2. Description of the Related Art

In recent years, with the increased down-scaling of semiconductor devices progresses due to the development of electronic technology, high integration and low power consumption of semiconductor chips are required. To respond to the demands for high integration and low power consumption, feature sizes of semiconductor devices are continuously decreasing.

As various contact types are used for connections between wirings, the length of the contact may increase. This may increase the contact resistance.

US 2019/013236 A1 relates to semiconductor structures and, more particularly, to fully aligned via structures having relaxed gapfills and methods of manufacture. The method includes: selectively depositing a capping material on a conductive material within a plurality of interconnect structures to form capped interconnect structures; depositing at least one insulator material over the capped interconnect structures; forming a fully aligned via structure through the at least one insulator material to expose the capping material; filling the fully aligned via structure with an alternative metal; and depositing a metal material on the alternative metal in the fully aligned via structure.

US 2020/335348 A1 discloses: A method of manufacturing an integrated circuit device includes sequentially forming a device layer, a wiring insulating layer, and a hard mask layer on a semiconductor substrate. The method includes sequentially removing a first region and a second region of the hard mask layer by using a first mask layer having a first opening and a second mask layer having a second opening as an etch mask, respectively. The method includes forming a first wiring recess through the wiring insulating layer and a second wiring recess having a depth that is less than that of the first wiring recess by removing a portion of the wiring insulation layer by using a portion of the hard mask layer as an etching mask. Moreover, the method includes forming a wiring structure that is in the first wiring recess and the second wiring recess.

US 2020/083094 A1 discloses: A method of fabricating an interconnection line of a semiconductor device includes forming a via and a lower interconnection trench in a first interlayer insulating layer, an etch stop layer, and a second interlayer insulating layer on a substrate, forming a lower diffusion barrier layer, a lower seed layer, and a lower interconnection layer inside the via and the lower interconnection trench, planarizing the lower interconnection layer using a chemical mechanical polishing (CMP) process to form a contact plug and a lower interconnection line, depositing a third interlayer insulating layer on top of a second interlayer insulating pattern and the lower interconnection line, forming an upper interconnection trench in the third interlayer insulating layer, forming an upper diffusion barrier layer, an upper seed layer, and an upper interconnection layer inside the upper interconnection trench, and planarizing the upper interconnection layer using a CMP process to form an upper interconnection line.

### SUMMARY

Embodiments of the present invention are set out in the appended claims. Embodiments of the present disclosure provide a semiconductor device with improved device performance and reliability by forming a conductive insertion pattern between a lower wiring line and an upper via.

### BRIEF DESCRIPTION OF THE DRAWINGS

FIG. 1 is an exemplary layout diagram of a semiconductor device according to some embodiments.
FIG. 2 is an exemplary cross-sectional view taken along line A-A of FIG. 1.
FIG. 3 is an exemplary cross-sectional view taken along line B-B of FIG. 1.
FIG. 4 is an exemplary cross-sectional view taken along line C-C of FIG. 1.
FIG. 5 illustrates a semiconductor device according to some embodiments.
FIG. 6 illustrates a semiconductor device according to some embodiments.
FIG. 7 illustrates a semiconductor device according to some embodiments.
FIGS. 8 and 9 illustrate a semiconductor device according to some embodiments.
FIG. 10 illustrates a semiconductor device according to some embodiments.
FIG. 11 illustrates a semiconductor device according to some embodiments.
FIG. 12 illustrates a semiconductor device according to some embodiments.
FIGS. 13 to 15 illustrate a semiconductor device according to some embodiments.
FIGS. 16 to 18 illustrate a semiconductor device according to some embodiments.
FIGS. 19 and 20 illustrate a semiconductor device according to some embodiments;
FIG. 21 illustrates a semiconductor device according to some embodiments.
FIG. 22 illustrates a semiconductor device according to some embodiments.
FIGS. 23 to 25 illustrate a semiconductor device according to some embodiments.
FIGS. 26A to 29B illustrate intermediate steps of a method for fabricating a semiconductor device according to some embodiments.

### DETAILED DESCRIPTION OF EMBODIMENTS

The drawings of a semiconductor device according to some embodiments illustrate a fin-shaped transistor (FinFET) that includes a channel region of a fin-shaped pattern, a transistor that includes a nanowire or a nanosheet, and a multi-bridge channel field effect transistor (MBCFET^{™}) or a vertical transistor (vertical FET), but embodiments are is not limited thereto. A semiconductor device according to some embodiments may include a tunneling field effect transistor (TFET) or a three-dimensional (3D) transistor. In addition, a semiconductor device according to some embodiments may include a planar transistor. In addition, the technical spirit of the present disclosure can be applied to transistors based on two-dimensional materials (2D material based FETs) and heterostructures thereof.

Further, a semiconductor device according to some embodiments may include a bipolar junction transistor, a lateral double diffusion MOS (LDMOS) transistor, etc.

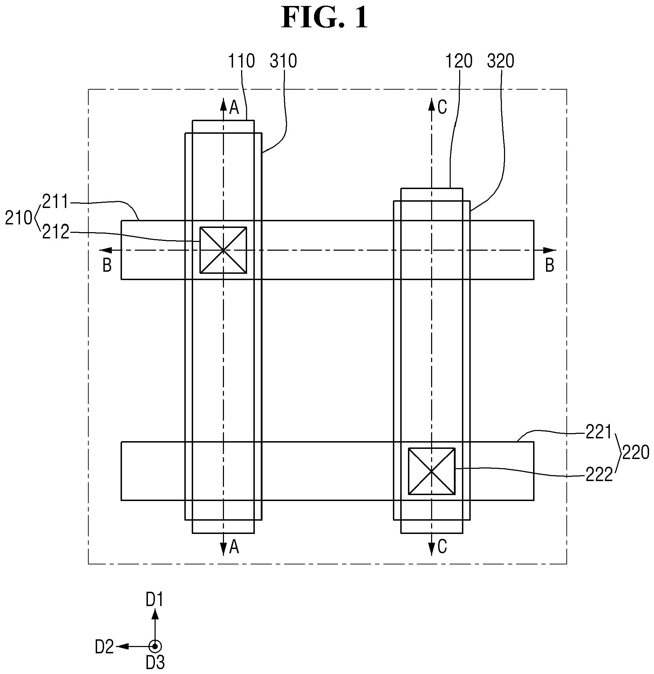

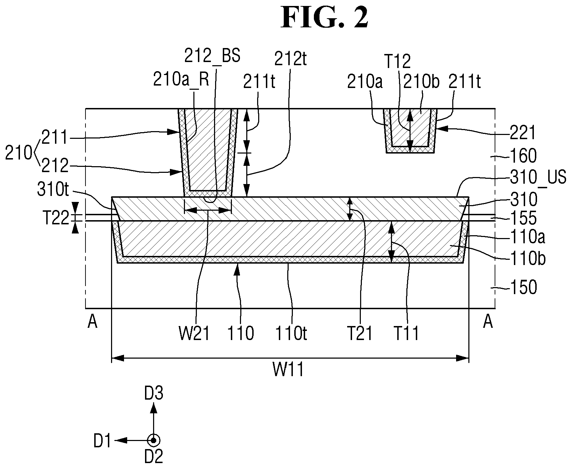

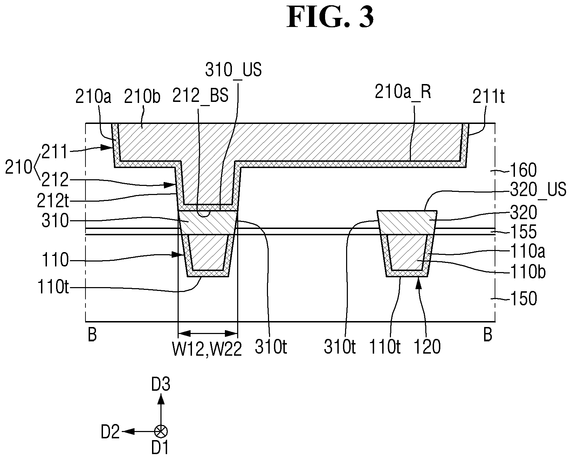

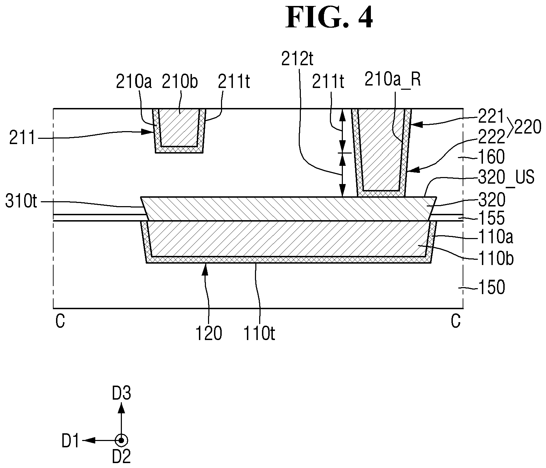

FIG. 1 is an exemplary layout diagram of a semiconductor device according to some embodiments. FIG. 2 is an exemplary cross-sectional view taken along line A-A of FIG. 1. FIG. 3 is an exemplary cross-sectional view taken along line B-B of FIG. 1. FIG. 4 is an exemplary cross-sectional view taken along line C-C of FIG. 1.

Referring to FIGS. 1 to 4, a semiconductor device according to some embodiments includes a first conductive lower wiring 110, a second conductive lower wiring 120, a first upper wiring structure 210, and a second upper wiring structure 220, a first conductive insertion pattern 310, and a second conductive insertion pattern 320.

Each of the first conductive lower wiring 110 and the second conductive lower wiring 120 is disposed in a first interlayer insulating layer 150. Each of the first conductive lower wiring 110 and the second conductive lower wiring 120 extends in a first direction D1. The first conductive lower wiring 110 and the second conductive lower wiring 120 are spaced apart from each other in a second direction D2.

Each of the first conductive lower wiring 110 and the second conductive lower wiring 120 has a line shape that extends in the first direction D1. For example, the first direction D1 may be a longitudinal direction of the first conductive lower wiring 110 and the second conductive lower wiring 120, and the second direction D2 may be a width direction of the first conductive lower wiring 110 and the second conductive lower wiring 120. Here, the first direction D1 intersects the second direction D2 and a third direction D3. The second direction D2 intersects the third direction D3. In an embodiment, the first direction D1, the second direction D2, and the third direction D3 are all mutually perpendicular.

Although the first conductive lower wiring 110 and the second conductive lower wiring 120 are illustrated as being adjacent to each other in the second direction D2, embodiments of the present disclosure are not limited thereto. For example, in some embodiments, an additional conductive lower wiring may be disposed between the first conductive lower wiring 110 and the second conductive lower wiring 120. In addition, the length in the first direction D1 of the first conductive lower wiring 110 is illustrated as being different from the length in the first direction D1 of the second conductive lower wiring 120, embodiments of the present disclosure are not limited thereto.

In an embodiment, the first interlayer insulating layer 150 covers a gate electrode and a source/drain of a transistor formed in a front-end-of-line (FEOL) process. Alternatively, in an embodiment, the first interlayer insulating layer 150 is an interlayer insulating layer formed in a back-end-of-line (BEOL) process.

In other words, in an embodiment, each of the first conductive lower wiring 110 and the second conductive lower wiring 120 is a contact or a contact wiring formed in a middle-of-line (MOL) process. In an embodiment, the first conductive lower wiring 110 and the second conductive lower wiring 120 are connection wirings formed in a back-end-of-line (BEOL) process. The following description is directed to an embodiment in which the first conductive lower wiring 110 and the second conductive lower wiring 120 are connecting wirings formed in the BEOL process.

The first interlayer insulating layer 150 includes, for example, at least one of silicon oxide, silicon nitride, silicon oxynitride, or a low-k material. The low-k material may be, for example, a silicon oxide that has a suitably high carbon and hydrogen content, and may be a material such as SiCOH. However, since carbon is included in the insulating material, the dielectric constant of the insulating material may be lowered. However, in an embodiment, to further lower the dielectric constant of the insulating material, the insulating material includes pores within the insulating material that are gas-filled or air-filled cavities.

The low-k material may be, for example, at least one of fluorinated tetraethylorthosilicate (FTEOS), hydrogen silsesquioxane (HSQ), bis-benzocyclobutene (BCB), tetramethylorthosilicate (TMOS), octamethyleyclotetrasiloxane (OMCTS), hexamethyldisiloxane (HMDS), trimethylsilyl borate (TMSB), diacetoxyditertiarybutosiloxane (DADBS), trimethylsilil phosphate (TMSP), polytetrafluoroethylene (PTFE), tonen silazene (TOSZ), fluoride silicate glass (FSG), polyimide nanofoams such as polypropylene oxide, carbon doped silicon oxide (CDO), organo silicate glass (OSG), SiLK, amorphous fluorinated carbon, silica aerogels, silica xerogels, mesoporous silica, or a combination thereof, but is not limited thereto.

Each of the first conductive lower wiring 110 and the second conductive lower wiring 120 is disposed at a first metal level. The first interlayer insulating layer 150 includes lower wiring trenches 110t that extend in the first direction D1.

Each of the first conductive lower wiring 110 and the second conductive lower wiring 120 is disposed in a lower wiring trench 110t. Each of the first conductive lower wiring 110 and the second conductive lower wiring 120 fills the lower wiring trench 110t.

Each of the first conductive lower wiring 110 and the second conductive lower wiring 120 includes a lower wiring barrier layer 110a and a lower wiring filling layer 110b. The lower wiring filling layer 110b is disposed on the lower wiring barrier layer 1 10a. Each of the first conductive lower wiring 110 and the second conductive lower wiring 120 has a multilayer structure.

The lower wiring barrier layer 110a extends along the sidewall and the bottom surface of the lower wiring trench 110t. The lower wiring filling layer 110b fills the remainder of the lower wiring trench 110t.

The lower wiring barrier layer 110a includes at least one of, for example, tantalum (Ta), tantalum nitride (TaN), titanium (Ti), titanium nitride (TiN), titanium silicon nitride (TiSiN), ruthenium (Ru), cobalt (Co), nickel (Ni), nickel boron (NiB), tungsten (W), tungsten nitride (WN), tungsten carbonitride (WCN), zirconium (Zr), zirconium nitride (ZrN), vanadium (V), vanadium nitride (VN), niobium (Nb), niobium nitride (NbN), platinum (Pt), iridium (Ir), rhodium (Rh), or a two-dimensional (2D) material. In a semiconductor device according to some embodiments, the 2D material may be a metal and/or a semiconductor. The 2D material may include a 2D allotrope or a 2D compound. For example, the 2D material may include at least one of graphene, molybdenum disulfide (MoS₂), molybdenum diselenide (MoSe₂), tungsten diselenide (WSe₂), or tungsten disulfide (WS₂), but embodiments are not limited thereto. However, the above-mentioned 2D materials are merely examples, and the 2D materials are not limited thereto in other embodiments.

The lower wiring filling layer 110b includes at least one of, for example, aluminum (Al), copper (Cu), tungsten (W), cobalt (Co), ruthenium (Ru), silver (Ag), gold (Au), manganese (Mn), molybdenum (Mo), rhodium (Rh), iridium (Ir), RuAl, NiAl, NbB₂, MoB₂, TaB₂, V₂AlC, or CrAlC. When the lower wiring filling layer 110b includes copper (Cu), the lower wiring filling layer 110b also includes, for example, carbon (C), silver (Ag), cobalt (Co), tantalum (Ta), indium (In), tin (Sn), zinc (Zn), manganese (Mn), titanium (Ti), magnesium (Mg), chromium (Cr), germanium (Ge), strontium (Sr), platinum (Pt), magnesium (Mg), aluminum (Al), or zirconium (Zr), etc.

In an embodiment, as the distance from the upper surface of the first interlayer insulating layer 150 increases, the widths in the first direction D1 of the first conductive lower wiring 110 and the second conductive lower wiring 120 decrease. In addition, as the distance from the upper surface of the first interlayer insulating layer 150 increases, the widths in the second direction D2 of the first conductive lower wiring 110 and the second conductive lower wiring 120 decrease.

However, embodiments are not limited thereto, and in other embodiments, each of the first conductive lower wiring 110 and the second conductive lower wiring 120 has a single layer structure.

In addition, in an embodiment, a via pattern is disposed that connects the first conductive lower wiring 110 and a conductive pattern disposed under the first conductive lower wiring 110. Similarly, a via pattern is disposed that connects the second conductive lower wiring 120 to a conductive pattern disposed under the second conductive lower wiring 120.

A second interlayer insulating layer 160 is disposed above the first conductive lower wirings 110, the second conductive lower wirings 120 and the first interlayer insulating layer 150. The second interlayer insulating layer 160 include an insertion pattern trench 310t, an upper via hole 212t, and an upper wiring trench 211t.

A first etch stop layer 155 is disposed on the first interlayer insulating layer 150 and under the second interlayer insulating layer 160, i.e., between the interlayer insulating layer 150 and the second interlayer insulating layer 160. The first etch stop layer 155 is disposed on the first conductive lower wirings 110, the second conductive lower wirings 120, and the first interlayer insulating layer 150.

The second interlayer insulating layer 160 includes, for example, at least one of silicon oxide, silicon nitride, silicon oxynitride, or a low-k material.

The first etch stop layer 155 includes a material having an etch selectivity with respect to the second interlayer insulating layer 160. The first etch stop layer 155 includes, for example, at least one of silicon nitride (SiN), silicon oxynitride (SiON), silicon oxycarbonitride (SiOCN), silicon boron nitride (SiBN), silicon oxyboron nitride (SiOBN), silicon oxycarbide (SiOC), aluminum oxide (AlO), aluminum nitride (AlN) or aluminum oxycarbide (AlOC), or a combination thereof. Although the first etch stop layer 155 is illustrated as having a single layer, this is merely for simplicity of description and embodiments of the present disclosure are not limited thereto. In other embodiments, the first etch stop layer 155 includes a plurality of insulating layers sequentially stacked on the first interlayer insulating layer 150.

The insertion pattern trench 310t extends in the first direction D1. The insertion pattern trench 3 10t exposes at least a part of the upper surface of the first conductive lower wiring 110 and at least a part of the upper surface of the second conductive lower wiring 120. The insertion pattern trench 310t penetrates the first etch stop layer 155. The sidewall of the insertion pattern trench 310t does not extend to the upper surface of the second interlayer insulating layer 160. The insertion pattern trench 310t is formed inside the second interlayer insulating layer 160 and extends into the second interlayer insulating layer 160 from the first interlayer insulating layer 150.

Each of the first conductive insertion pattern 310 and the second conductive insertion pattern 320 is disposed in the insertion pattern trench 310t. Each of the first conductive insertion pattern 310 and the second conductive insertion pattern 320 fills the insertion pattern trench 310t. Each of the first conductive insertion pattern 310 and the second conductive insertion pattern 320 is disposed inside and under the second interlayer insulating layer 160.

The first conductive insertion pattern 310 is disposed on the first conductive lower wiring 110. For example, the first conductive insertion pattern 310 extends along the upper surface of the first conductive lower wiring 110. The first conductive insertion pattern 310 is directly connected to the first conductive lower wiring 110. The first conductive insertion pattern 310 is in contact with the upper surface of the first conductive lower wiring 110. The first conductive insertion pattern 310 is disposed directly on the first conductive lower wiring 110. The first conductive insertion pattern 310 is not connected to the second conductive lower wiring 120.

The second conductive insertion pattern 320 is disposed on the second conductive lower wiring 120. For example, the second conductive insertion pattern 320 extends along the upper surface of the second conductive lower wiring 120. The second conductive insertion pattern 320 is directly connected to the second conductive lower wiring 120. The second conductive insertion pattern 320 is in contact with the upper surface of the second conductive lower wiring 120. The second conductive insertion pattern 320 is disposed directly on the second conductive lower wiring 120. The second conductive insertion pattern 320 is not connected to the first conductive lower wiring 110.

In an embodiment, each of the first conductive insertion pattern 310 and the second conductive insertion pattern 320 has a line shape that extends in the first direction D1. The first conductive insertion pattern 310 and the second conductive insertion pattern 320 are spaced apart from each other in the second direction D2.

In a semiconductor device according to some embodiments, each of the first conductive insertion pattern 310 and the second conductive insertion pattern 320 has a single layer structure. Each of the first conductive insertion pattern 310 and the second conductive insertion pattern 320 has a structure formed of a single layer. That is, each of the first conductive insertion pattern 310 and the second conductive insertion pattern 320 has a single conductive layer structure.

Each of the first conductive insertion pattern 310 and the second conductive insertion pattern 320 includes, for example, one of tungsten (W), cobalt (Co), ruthenium (Ru), silver (Ag), gold (Au), manganese (Mn), molybdenum (Mo), rhodium (Rh), iridium (Ir), RuAl, NiAl, NbB₂, MoB₂, TaB₂, V₂AlC, or CrAlC.

In an embodiment, as the distance from the upper surface of the first interlayer insulating layer 150 increases, the widths in the first direction D1 of the first conductive insertion pattern 310 and the second conductive insertion pattern 320 increase. In addition, as the distance from the upper surface of the first interlayer insulating layer 150 increases, the widths in the second direction D2 of the first conductive insertion pattern 310 and the second conductive insertion pattern 320 increase.

The upper wiring trench 211t extends in the second direction D2. The sidewall of the upper wiring trench 211t extends to the upper surface of the second interlayer insulating layer 160.

The upper via hole 212t is disposed at the bottom surface of the upper wiring trench 211t. The upper via hole 212t exposes a part of the first conductive insertion pattern 310 and the second conductive insertion pattern 320. A part of a upper surface 310_US of the first conductive insertion pattern 310 and a part of a upper surface 320_US of the second conductive insertion pattern 320 is exposed through the upper via hole 212t.

The first upper wiring structure 210 and the second upper wiring structure 220 are respectively disposed in the upper wiring trench 211t and the upper via hole 212t. Each of the first upper wiring structure 210 and the second upper wiring structure 220 fills the upper wiring trench 211t and the upper via hole 212t. The first upper wiring structure 210 and the second upper wiring structure 220 are disposed in the second interlayer insulating layer 160.

The first upper wiring structure 210 includes a first conductive upper wiring 211 and a first conductive upper via 212. The second upper wiring structure 220 includes a second conductive upper wiring 221 and a second conductive upper via 222.

Each of the first conductive upper wiring 211 and the second conductive upper wiring 221 fills the upper wiring trench 211t. Each of the first conductive upper wiring 211 and the second conductive upper wiring 221 is disposed at a second metal level that differs from the first metal level. The second metal level is higher than the first metal level. Each of the first conductive upper via 212 and the second conductive upper via 222 fills the upper via hole 212t.

The first conductive insertion pattern 310 is disposed between the first upper wiring structure 210 and the first conductive lower wiring 110. The first upper wiring structure 210 is directly connected to the first conductive insertion pattern 310. The first upper wiring structure 210 is in contact with the upper surface 310_US of the first conductive insertion pattern.

The first upper wiring structure 210 is connected to the first conductive lower wiring 110. The first upper wiring structure 210 is connected to the first conductive lower wiring 110 through the first conductive insertion pattern 310. The first conductive upper via 212 is connected to the first conductive insertion pattern 310. For example, the first conductive upper via 212 is directly connected to the first conductive insertion pattern 310. The first conductive upper via 212 is in contact with the upper surface 310_US of the first conductive insertion pattern. The first conductive insertion pattern 310 is disposed directly under the first conductive upper via 212.

The second conductive insertion pattern 320 is disposed between the second upper wiring structure 220 and the second conductive lower wiring 120. The second upper wiring structure 220 is directly connected to the second conductive insertion pattern 320. The second upper wiring structure 220 is in contact with the upper surface 320_US of the second conductive insertion pattern.

The second upper wiring structure 220 is connected to the second conductive lower wiring 120. The second upper wiring structure 220 is connected to the second conductive lower wiring 120 through the second conductive insertion pattern 320. The second conductive upper via 222 is connected to the second conductive insertion pattern 320. For example, the second conductive upper via 222 is directly connected to the second conductive insertion pattern 320. The second conductive upper via 222 is in contact with the upper surface 320_US of the second conductive insertion pattern. The second conductive insertion pattern 320 is disposed directly under the second conductive upper via 222.

The second interlayer insulating layer 160 covers a part of the upper surface 310_US of the first conductive insertion pattern and a part of the upper surface 320_US of the second conductive insertion pattern. More specifically, the second interlayer insulating layer 160 covers those portions of the upper surface 310_US of the first conductive insertion pattern and the upper surface 320_US of the second conductive insertion pattern that are not exposed by the upper via hole 212t.

Each of the first upper wiring structure 210 and the second upper wiring structure 220 includes an upper barrier conductive layer 210a and an upper filling conductive layer 210b. The upper filling conductive layer 210b is disposed on the upper barrier conductive layer 210a.

The upper barrier conductive layer 210a extends along the sidewall and the bottom surface of the upper wiring trench 211t and the sidewall and the bottom surface of the upper via hole 212t. The upper filling conductive layer 210b fills a filling recess 210a_R defined by the upper barrier conductive layer 210a.

Each of the first conductive upper wiring 211, the second conductive upper wiring 221, the first conductive upper via 212, and the second conductive upper via 222 includes the upper barrier conductive layer 210a and the upper filling conductive layer 210b. The upper filling conductive layer 210b in the first conductive upper wiring 211 is directly connected to the upper filling conductive layer 210b in the first conductive upper via 212. The upper filling conductive layer 210b in the second conductive upper wiring 221 is directly connected to the upper filling conductive layer 210b in the second conductive upper via 222.

The materials in the upper barrier conductive layer 210a and the upper filling conductive layer 210b are the same as those described with regard to the lower wiring barrier layer 110a and the lower wiring filling layer 110b.

In an embodiment, as the distance from the upper surface of the first interlayer insulating layer 150 increases, the widths in the first direction D1 of the first conductive upper wiring 211 and the second conductive upper wiring 221 increase. Further, as the distance from the upper surface of the first interlayer insulating layer 150 increases, the widths in the second direction D2 of the first conductive upper wiring 211 and the second conductive upper wiring 221 increase.

Although is the figures illustrate that the first conductive upper wiring 211 crosses and is spaced above the second conductive lower wiring 120 in the third direction D3, embodiments of the present disclosure are not limited thereto. In other embodiments, the first conductive upper wiring 211 does not overlap the second conductive lower wiring 120 in the third direction D3. Although is the figures illustrate that the second conductive upper wiring 221 crosses and is spaced apart from the first conductive lower wiring 110 in the third direction, embodiments of the present disclosure are not limited thereto. In other embodiments, the second conductive upper wiring 221 does not overlap the first conductive lower wiring 110 in the third direction D3.

The relationship between the second upper wiring structure 220 and the second conductive insertion pattern 320 is substantially the same as the relationship between the first upper wiring structure 210 and the first conductive insertion pattern 310. The following description will focus on the relationship between the first upper wiring structure 210 and the first conductive insertion pattern 310.

In an embodiment, a thickness T21 of the first conductive insertion pattern 310 is greater than a thickness T22 of the first etch stop layer 155. The first conductive insertion pattern 310 protrudes in the third direction D3 further than the first etch stop layer 155. Further, a thickness T21 of the first conductive insertion pattern 310 is less than a thickness T11 of the first conductive lower wiring 110 and a thickness T12 of the first conductive upper wiring 211.

In FIGS. 2 and 3, the upper surface 310_US of the first conductive insertion pattern has a first width W11 in the first direction D1. The upper surface 310_US of the first conductive insertion pattern has a second width W12 in the second direction D2. With respect to the upper surface 310_US of the first conductive insertion pattern, a bottom surface 212_BS of the first conductive upper via has a third width W21 in the first direction D1. With respect to the upper surface 310_US of the first conductive insertion pattern, the bottom surface 212_BS of the first conductive upper via has a fourth width W22 in the second direction D2. In other words, the bottom surface of the first upper wiring structure 210 is the bottom surface 212_BS of the first conductive upper via. The bottom surface of the first upper wiring structure 210 has the third width W21 in the first direction D1 and the fourth width W22 in the second direction D2.

In a semiconductor device according to some embodiments, the third width W21 of the bottom surface 212_BS of the first conductive upper via is less than the first width W11 of the upper surface 310_US of the first conductive insertion pattern. The fourth width W22 of the bottom surface 212_BS of the first conductive upper via is equal to the second width W12 of the upper surface 310_US of the first conductive insertion pattern.

In other words, in a plan view, the area of the upper surface 310_US of the first conductive insertion pattern is greater than the area of the bottom surface 212_BS of the first conductive upper via. The area of the bottom surface 212_BS of the first conductive upper via is based on the upper surface 310_US of the first conductive insertion pattern.

Since the first conductive insertion pattern 310 is directly connected to the first conductive lower wiring 110, the first conductive lower wirings 110, which extend in the first direction D1, are connected in parallel. That is, the resistance between ends of the first conductive lower wirings 110 is reduced.

Further, since the area of the upper surface 310_US of the first conductive insertion pattern is greater than the area of the bottom surface 212_BS of the first conductive upper via, the first conductive upper via 212 is more easily placed on the first conductive insertion pattern 310.

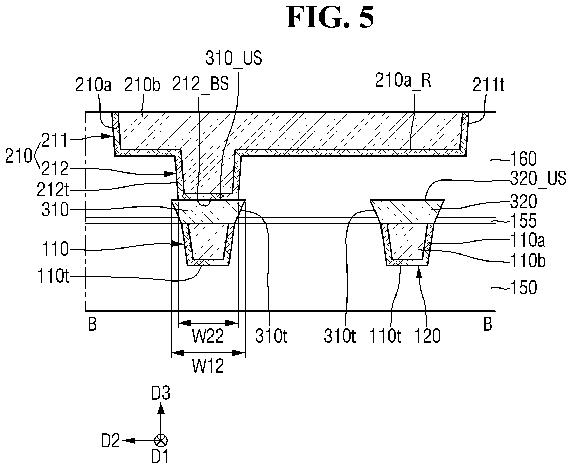

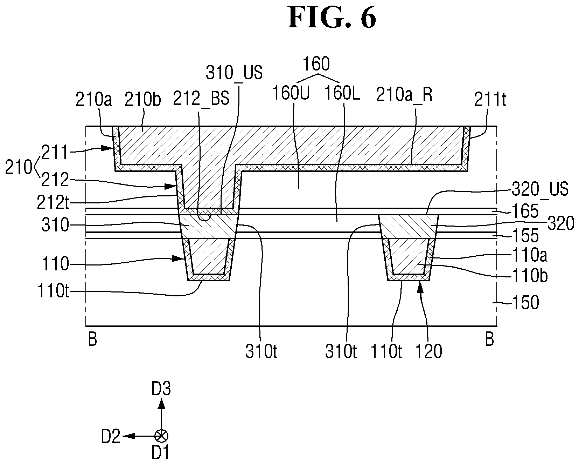

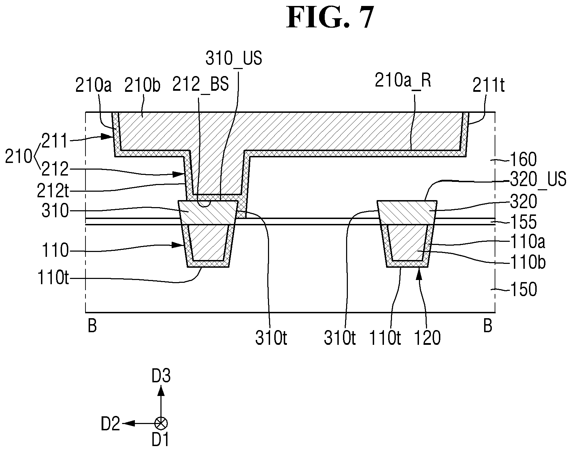

FIG. 5 illustrates a semiconductor device according to some embodiments. FIG. 6 illustrates a semiconductor device according to some embodiments. FIG. 7 illustrates a semiconductor device according to some embodiments. For simplicity of description, the following description will focus on differences with reference to FIGS. 1 to 4.

Referring to FIG. 5, in a semiconductor device according to some embodiments, the fourth width W22 of the bottom surface 212_BS of the first conductive upper via is less than the second width W12 of the upper surface 310_US of the first conductive insertion pattern.

In other words, the fourth width W22 of the bottom surface of the first upper wiring structure 210 is less than the second width W12 of the upper surface 310_US of the first conductive insertion pattern.

The first width W11 of the upper surface 310_US of the first conductive insertion pattern 310 is greater than the third width W21 of the bottom surface 212_BS of the first conductive upper via 212, and the second width W12 of the upper surface 310_US of the first conductive insertion pattern 310 is greater than the fourth width W22 of the bottom surface 212_BS of the first conductive upper via 212, so that the first conductive upper via 212 is more easily placed on the first conductive insertion pattern 310.

Referring to FIG. 6, a semiconductor device according to some embodiments further includes a second etch stop layer 165 disposed in the second interlayer insulating layer 160.

The second etch stop layer 165 is disposed on the upper surface 310_US of the first conductive insertion pattern 310 and the upper surface 320_US of the second conductive insertion pattern 320. The second interlayer insulating layer 160 may be divided into a second lower interlayer insulating layer 160L and a second upper interlayer insulating layer 160U by the second etch stop layer 165. The second etch stop layer 165 is interposed between the second lower interlayer insulating layer 160L and the second upper interlayer insulating layer 160U. In an embodiment, an upper surface of the second lower interlayer insulating layer 160L is coplanar with the upper surface 310_US of the first conductive insertion pattern 310 and the upper surface 320_US of the second conductive insertion pattern 320.

The upper via hole 212t penetrates the second etch stop layer 165. The first conductive upper via 212 in the upper via hole 212t penetrates the second etch stop layer 165 to be connected to the first conductive insertion pattern 310.

The second etch stop layer 165 includes a material having an etch selectivity with respect to the second upper interlayer insulating layer 160U. The second etch stop layer 165 includes, for example, at least one of silicon nitride (SiN), silicon oxynitride (SiON), silicon oxycarbonitride (SiOCN), silicon boron nitride (SiBN), silicon oxyboron nitride (SiOBN), silicon oxycarbide (SiOC), aluminum oxide (AlO), aluminum nitride (AlN) or aluminum oxycarbide (AlOC), or a combination thereof. For simplicity of description, the first etch stop layer 155 is illustrated as having a single layer, however, embodiments of the present disclosure are not limited thereto, and in other embodiments, the first etch stop layer 155 has multiple layers.

Referring to FIG. 7, in a semiconductor device according to some embodiments, the first upper wiring structure 210 is in contact with the first etch stop layer 155.

The first conductive upper via 212 is in contact with the upper surface 310_US of the first conductive insertion pattern and a sidewall of the first conductive insertion pattern 310. For example, in a process of forming the first upper wiring structure 210, the first conductive upper via 212 and the first conductive insertion pattern 310 may be misaligned.

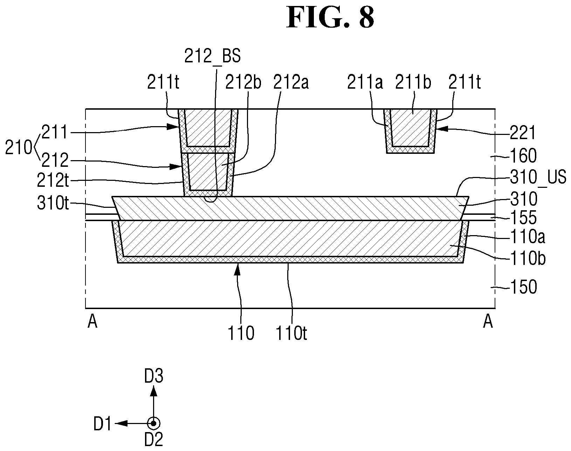

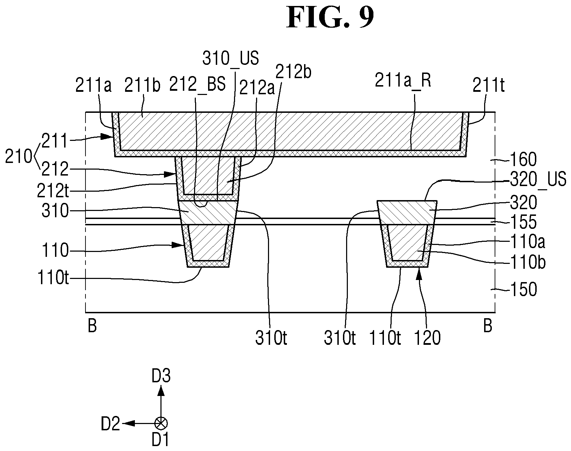

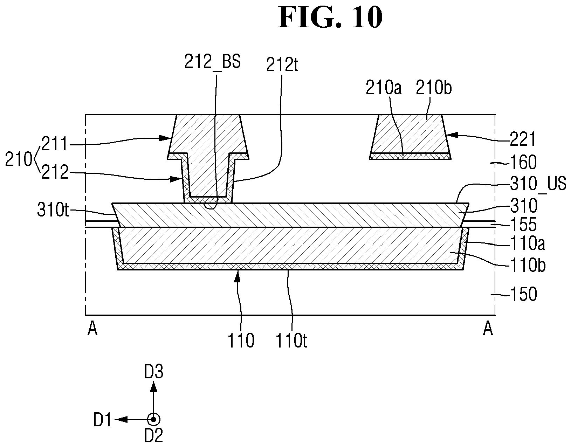

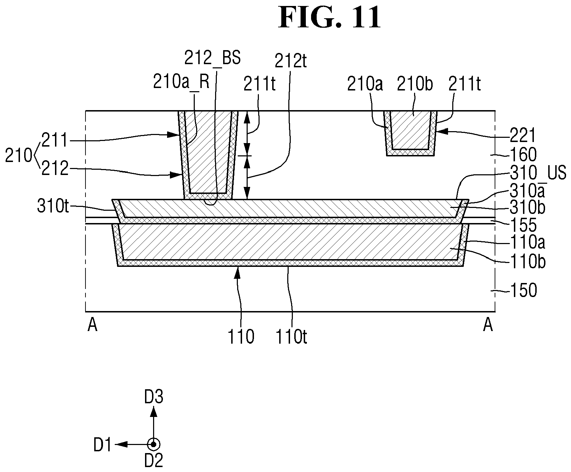

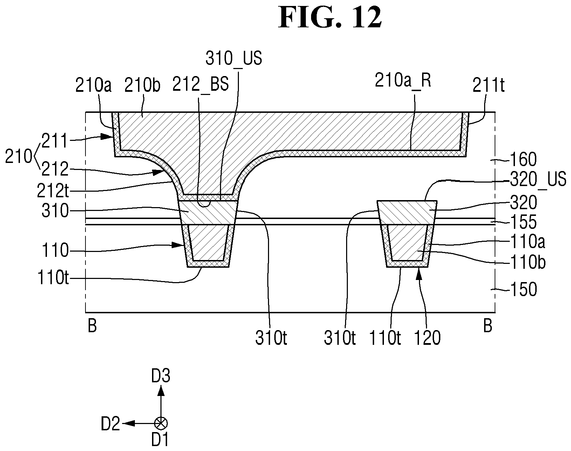

FIGS. 8 and 9 illustrate a semiconductor device according to some embodiments. FIG. 10 illustrates a semiconductor device according to some embodiments. FIG. 11 illustrates a semiconductor device according to some embodiments. FIG. 12 illustrates a semiconductor device according to some embodiments. For simplicity of description, the following description will focus on differences from the description with reference to FIGS. 1 to 4.

Referring to FIGS. 8 and 9, in a semiconductor device according to some embodiments, the first conductive upper wiring 211 and the second conductive upper wiring 221 each include an upper wiring barrier layer 211a and an upper wiring filling layer 21 1b. The first conductive upper via 212 and the second conductive upper via 222 each include an upper via barrier layer 212a and an upper via filling layer 212b.

The upper wiring barrier layer 211a extends along the sidewall and the bottom surface of the upper wiring trench 211t. The upper wiring filling layer 211b may be disposed on the upper wiring barrier layer 211a. The upper wiring filling layer 211b fills an upper wiring recess 211a_R defined by the upper wiring barrier layer 211a.

The upper via barrier layer 212a extends along the sidewall and the bottom surface of the upper via hole 212t. The upper via filling layer 212b is disposed on the upper via barrier layer 212a. The upper via filling layer 212b fills an upper via recess 212a_R defined by the upper via barrier layer 212a.

The upper wiring filling layer 211b is separated from the upper via filling layer 212b. The upper wiring barrier layer 211a separates the upper wiring filling layer 211b from the upper via filling layer 212b.

The materials included in the upper wiring barrier layer 211a and the upper via barrier layer 212a are the same as those described with regard to the lower wiring barrier layer 1 10a. The materials included in the upper wiring filling layer 211b and the upper via filling layer 212b are the same as those described with regard to the lower wiring filling layer 110b.

In an embodiment, the first conductive upper via 212 and the second conductive upper via 222 have a single layer structure. The first conductive upper via 212 and the second conductive upper via 222 do not include the upper via barrier layer 212a.

In an embodiment, the first conductive upper wiring 211 and the second conductive upper wiring 221 have a single layer structure. The first conductive upper wiring 211 and the second conductive upper wiring 221 do not include the upper wiring barrier layer 211a.

Referring to FIG. 10, in a semiconductor device according to some embodiments, as the distance from the upper surface of the first interlayer insulating layer 150 increases, the widths in the first direction D1 of the first conductive upper wiring 211 and the second conductive upper wiring 221 decrease.

In addition, as the distance from the upper surface of the first interlayer insulating layer 150 increases, the widths in the second direction D2 of the first conductive upper wiring 211 and the second conductive upper wiring 221 decrease.

Furthermore, as the distance from the upper surface of the first interlayer insulating layer 150 increases, the widths in the first direction D1 of the first conductive upper via 212 and the second conductive upper via 222 increase. Similarly, as the distance from the upper surface of the first interlayer insulating layer 150 increases, the widths in the second direction D2 of the first conductive upper via 212 and the second conductive upper via 222 increase.

The upper barrier conductive layer 210a is not disposed on the sidewall of the upper filling conductive layer 210b in the first conductive upper wiring 211 and the second conductive upper wiring 221.

Referring to FIG. 11, in a semiconductor device according to some embodiments, the first conductive insertion pattern 310 includes an insertion barrier conductive layer 310a and an insertion filling conductive layer 310b.

The insertion filling conductive layer 310b is disposed on the insertion barrier conductive layer 310a. The insertion barrier conductive layer 310a extends along the sidewall and the bottom surface of the insertion pattern trench 310t. The insertion filling conductive layer 310b fills the remainder of the insertion pattern trench 310t.

The materials included in the insertion barrier conductive layer 310a and the insertion filling conductive layer 310b are the same as those described with regard to the lower wiring barrier layer 110a and the lower wiring filling layer 110b.

In addition, the second conductive insertion pattern 320 has the same structure as the first conductive insertion pattern 310.

Referring to FIG. 12, in a semiconductor device according to some embodiments, the sidewall of the upper via hole 212t includes a curved surface.

As the distance from the upper surface of the first interlayer insulating layer 150 increases, the slope of the sidewall of the upper via hole 212t decrease. The sidewall of the upper via hole 212t curves from horizontal to vertical as the sidewall approaches the first conductive insertion pattern 310.

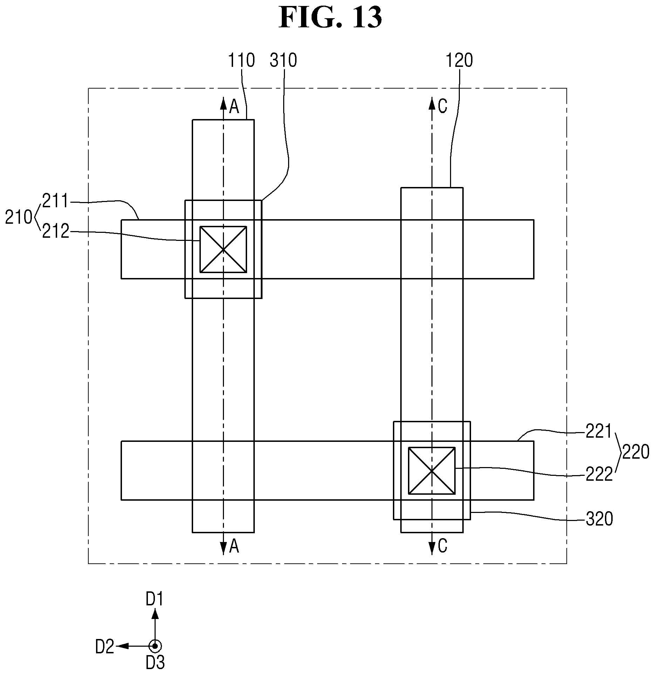

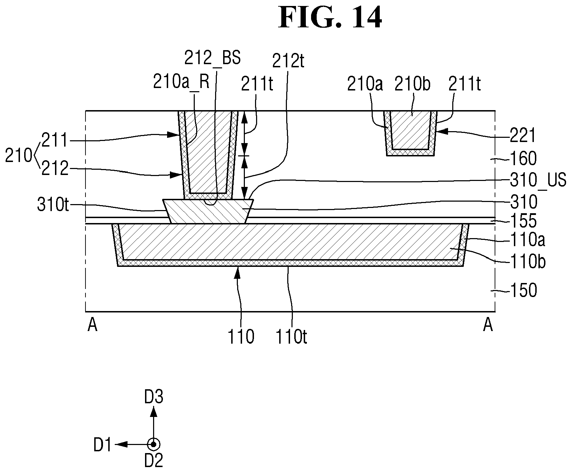

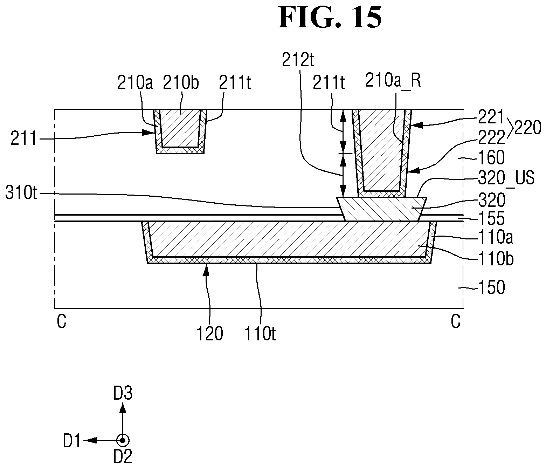

FIGS. 13 to 15 illustrate a semiconductor device according to some embodiments. For simplicity of description, the following description will focus on differences from the description with reference to FIGS. 1 to 4.

Referring to FIGS. 13 to 15, in a semiconductor device according to some embodiments, the first conductive insertion pattern 310 and the second conductive insertion pattern 320 have a contact type shape.

In other words, the first conductive insertion pattern 310 and the second conductive insertion pattern 320 are disposed at positions where the first conductive upper via 212 and the second conductive upper via 222 are disposed.

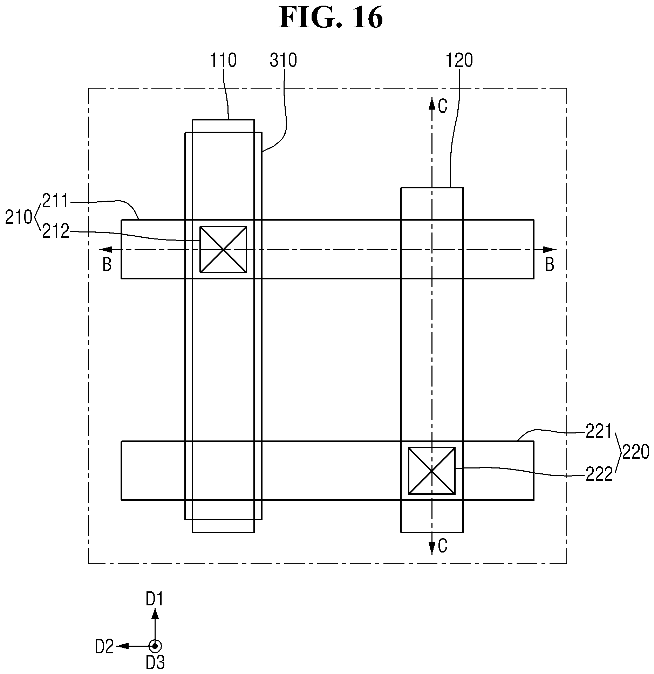

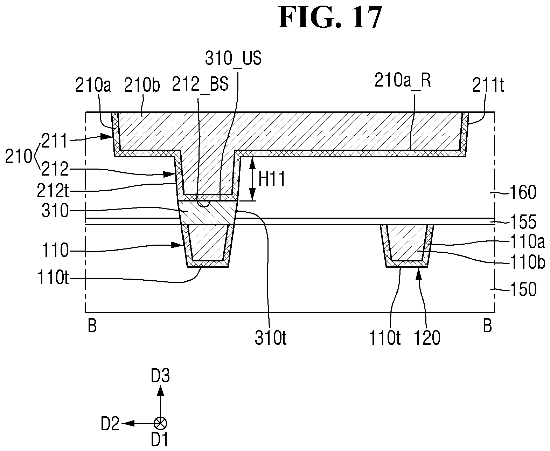

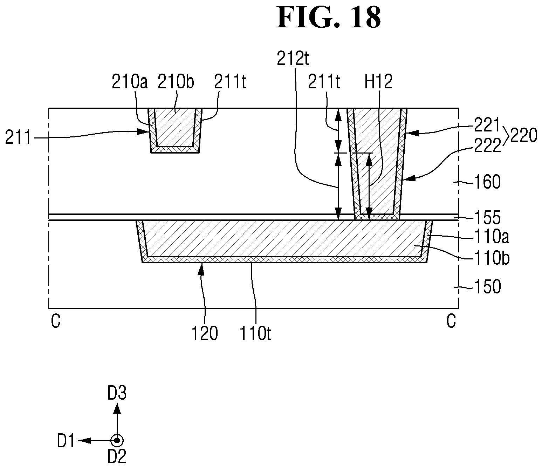

FIGS. 16 to 18 illustrate a semiconductor device according to some embodiments. For simplicity of description, the following description will focus on differences from the description with reference to FIGS. 1 to 4.

Referring to FIGS. 16 to 18, in a semiconductor device according to some embodiments, the second upper wiring structure 220 is directly connected to the second conductive lower wiring 120.

For example, the second conductive upper via 222 is directly connected to the second conductive lower wiring 120. The upper via hole 212t in which the second conductive upper via 222 is disposed penetrates the first etch stop layer 155. The second conductive upper via 222 penetrates the first etch stop layer 155 and is connected to the second conductive lower wiring 120.

A conductive insertion pattern is not disposed between the second conductive lower wiring 120 and the second upper wiring structure 220. Accordingly, a height H12 of the second conductive upper via 222 is greater than a height H11 of the first conductive upper via 212.

In an embodiment, the first conductive lower wiring 110 is a power supply line that supplies power to an element such as a transistor. The first conductive lower wiring 110 is connected to a power voltage or a ground voltage.

In an embodiment, the second conductive lower wiring 120 is a signal transmission line that transmits signals between elements such as transistors.

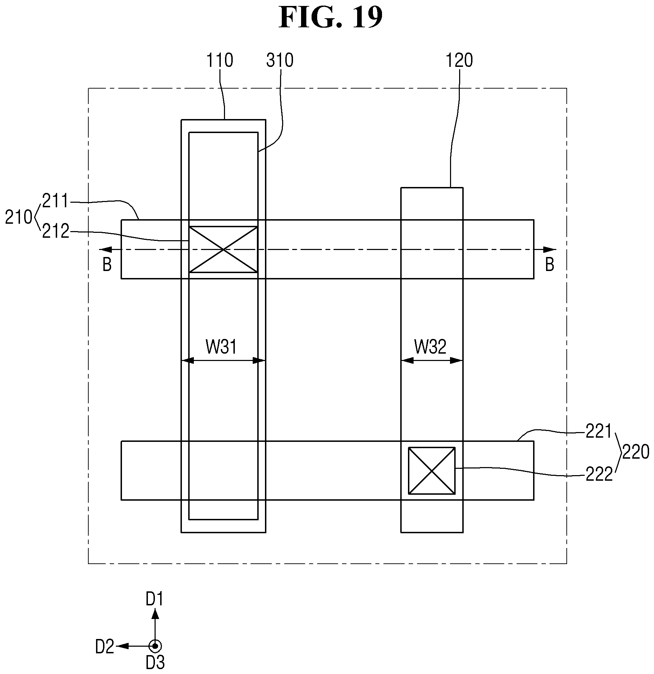

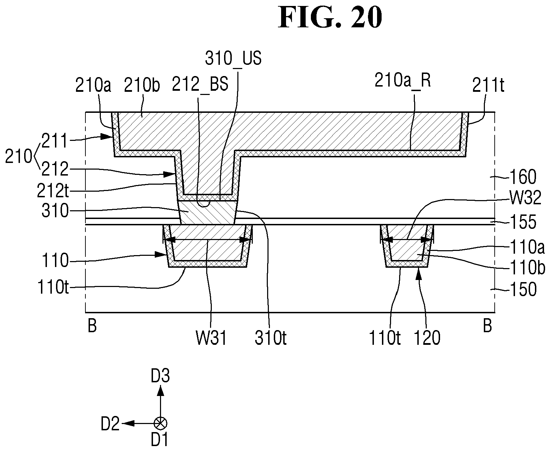

FIGS. 19 and 20 illustrate a semiconductor device according to some embodiments. For simplicity of description, the following description will focus on differences from the description with reference to FIGS. 16 to 18.

Referring to FIGS. 19 and 20, a width W31 in the second direction D2 of the first conductive lower wiring 110 is greater than a width W32 in the second direction D2of the second conductive lower wiring 120.

Although the width W31 in the second direction D2 of the first conductive insertion pattern 310 is shown as being less than the width W31 in the second direction D2 of the first conductive lower wiring 110, embodiments of the present disclosure are not limited thereto.

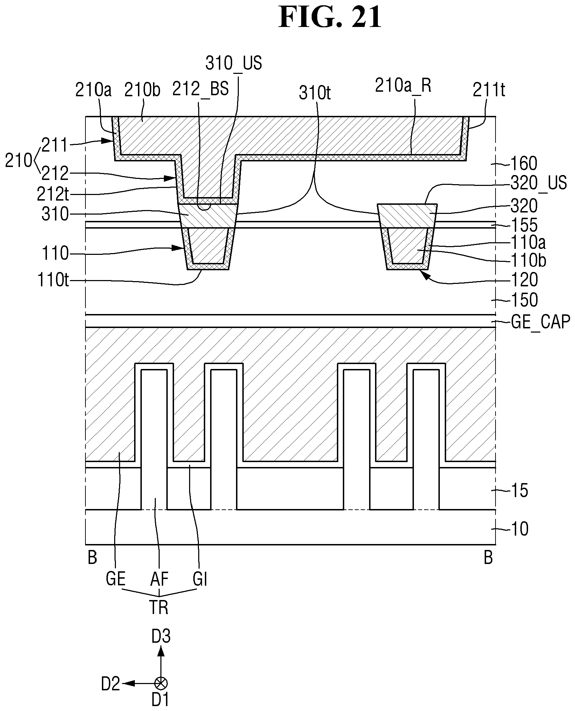

FIG. 21 illustrates a semiconductor device according to some embodiments. For simplicity of description, the following description will focus on differences from the description with reference to FIGS. 1 to 4.

For reference, FIG. 21 illustrates a cross section that includes a first gate electrode GE.

FIG. 21 illustrates a fin-shaped pattern AF that extends in the first direction D1 and the first gate electrode GE that extends in the second direction D2, but embodiments of the present disclosure are not limited thereto.

Referring to FIG. 21, a semiconductor device according to some embodiments includes a transistor TR disposed between the substrate 10 and the conductive lower wirings 110 and 120.

The substrate 10 may be a silicon substrate or silicon-on-insulator (SOI) substrate. Alternatively, the substrate 10 includes one of silicon germanium, silicon germanium on insulator (SGOI), indium antimonide, a lead tellurium compound, indium arsenide, indium phosphide, gallium arsenide, or gallium antimonide, but embodiments are not limited thereto.

The transistor TR includes the fin-shaped pattern AF, the first gate electrode GE on the fin-shaped pattern AF, and a first gate insulating layer GI between the fin-shaped pattern AF and the first gate electrode GE.

In addition, the transistor TR includes source/drain patterns disposed on both sides of the first gate electrode GE.

The fin-shaped pattern AF protrudes from the substrate 10. The fin-shaped pattern AF extends in the first direction D1. The fin-shaped pattern AF is a part of the substrate 10, and includes an epitaxial layer grown from the substrate 10. The fin-shaped pattern AF includes, for example, silicon or germanium, which are elemental semiconductor materials. In addition, the fin-shaped pattern AF may include a compound semiconductor, such as a group IV-IV compound semiconductor or a group III-V compound semiconductor.

The group IV-IV compound semiconductor is a binary compound or a ternary compound that includes at least two of carbon (C), silicon (Si), germanium (Ge) or tin (Sn), or an above-mentioned compound doped with a group IV element. The group III-V compound semiconductor is, for example, a binary compound, a ternary compound or a quaternary compound formed by combining at least one of aluminum (Al), gallium (Ga) or indium (In), which are group III elements, with one of phosphorus (P), arsenic (As) or antimonium (Sb), which are group V elements.

A field insulating layer 15 is formed on the substrate 10. The field insulating layer 15 is formed on a part of the sidewall of the fin-shaped pattern AF. The fin-shaped pattern AF protrudes above the upper surface of the field insulating layer 15. The field insulating layer 15 includes, for example, at least one of an oxide layer, a nitride layer, an oxynitride layer, or a combination layer thereof.

The first gate electrode GE is disposed on the fin-shaped pattern AF. The first gate electrode GE extends in the second direction D2. The first gate electrode GE intersects the fin-shaped pattern AF.

The first gate electrode GE includes, for example, at least one of a metal, a conductive metal nitride, a conductive metal carbonitride, a conductive metal carbide, a metal silicide, a doped semiconductor material, a conductive metal oxynitride, or a conductive metal oxide.

The first gate insulating layer GI is disposed between the first gate electrode GE and the fin-shaped pattern AF and between the first gate electrode GE and the field insulating layer 15. The first gate insulating layer GI includes, for example, at least one of silicon oxide, silicon oxynitride, silicon nitride, or a high-k material that has a dielectric constant higher than that of silicon oxide. The high-k material is, for example, at least one of boron nitride, a metal oxide, or a metal silicon oxide.

A semiconductor device according to some embodiments includes a negative capacitor FET that uses a negative capacitor. For example, the first gate insulating layer GI includes a ferroelectric material layer that has ferroelectric properties and a paraelectric material layer that has paraelectric properties.

The ferroelectric material layer has a negative capacitance, and the paraelectric material layer has a positive capacitance. For example, when two or more capacitors are connected in series and the capacitance of each capacitor has a positive value, the total capacitance is less than the capacitance of each capacitor individually. On the other hand, when at least one of the capacitances of two or more capacitors connected in series has a negative value, the total capacitance has a positive value and is greater than the absolute value of each capacitance.

When a ferroelectric material layer that has a negative capacitance and a paraelectric material layer that has a positive capacitance are connected in series, the total capacitance value of the series connected ferroelectric material layer and paraelectric material layer increases. By using the principle that the total capacitance value increases, a transistor that contains a ferroelectric material layer has a subthreshold swing less than or equal to a threshold voltage that is less than 60 mV/decade at room temperature.

A ferroelectric material layer has ferroelectric properties. The ferroelectric material layer includes, for example, at least one of hafnium oxide, hafnium zirconium oxide, barium strontium titanium oxide, barium titanium oxide, or lead zirconium titanium oxide. For example, the hafnium zirconium oxide contains hafnium oxide doped with zirconium (Zr). For another example, the hafnium zirconium oxide is a compound of hafnium (Hf), zirconium (Zr), and oxygen (O).

The ferroelectric material layer may further include a dopant doped therein. For example, the dopant includes at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), or tin (Sn). The type of dopant in the ferroelectric material layer varies depending on which ferroelectric material is in the ferroelectric material layer.

When the ferroelectric material layer includes hafnium oxide, the dopant n the ferroelectric material layer includes, for example, at least one of gadolinium (Gd), silicon (Si), zirconium (Zr), aluminum (Al), or yttrium (Y).

When the dopant is aluminum (Al), the ferroelectric material layer includes 3 to 8 atomic percent (at%) of aluminum. In this case, the dopant ratio is a ratio of aluminum to the sum of hafnium and aluminum.

When the dopant is silicon (Si), the ferroelectric material layer includes 2 to 10 at% of silicon. When the dopant is yttrium (Y), the ferroelectric material layer includes 2 to 10 at% of yttrium. When the dopant is gadolinium (Gd), the ferroelectric material layer includes 1 to 7 at% of gadolinium. When the dopant is zirconium (Zr), the ferroelectric material layer includes 50 to 80 at% of zirconium.

A paraelectric material layer has paraelectric properties. The paraelectric material layer includes, for example, at least one of sa ilicon oxide or a metal oxide that has a high dielectric constant. The metal oxide in the paraelectric material layer includes, for example, at least one of hafnium oxide, zirconium oxide, or aluminum oxide, but embodiments are not limited thereto.

The ferroelectric material layer and the paraelectric material layer may include the same material. The ferroelectric material layer has ferroelectric properties, but the paraelectric material layer does not have ferroelectric properties. For example, when the ferroelectric material layer and the paraelectric material layer include hafnium oxide, the crystal structure of the hafnium oxide in the ferroelectric material layer differs from the crystal structure of the hafnium oxide in the paraelectric material layer.

The ferroelectric material layer has a thickness that exhibits ferroelectric properties. The thickness of the ferroelectric material layer is, for example, in a range of 0.5 nm to 10 nm, but embodiments are not limited thereto. Since a critical thickness at which each ferroelectric material exhibits ferroelectric properties may be different, the thickness of the ferroelectric material layer may vary depending on the ferroelectric material.

In an embodiment, the first gate insulating layer GI includes one ferroelectric material layer. In an embodiment, the first gate insulating layer GI includes a plurality of ferroelectric material layers spaced apart from each other. The first gate insulating layer GI has a stacked structure in which a plurality of ferroelectric material layers and a plurality of paraelectric material layers are alternately stacked.

A gate capping pattern GE_CAP is disposed on the first gate electrode GE. The conductive lower wirings 110 and 120 are disposed on the first gate electrode GE. Although the conductive lower wirings 110 and 120 are shown as not being connected to the first gate electrode GE, embodiments of the present disclosure is not limited thereto, and in other embodiments, one of the conductive lower wirings 110 or 120 is connected to the first gate electrode GE.

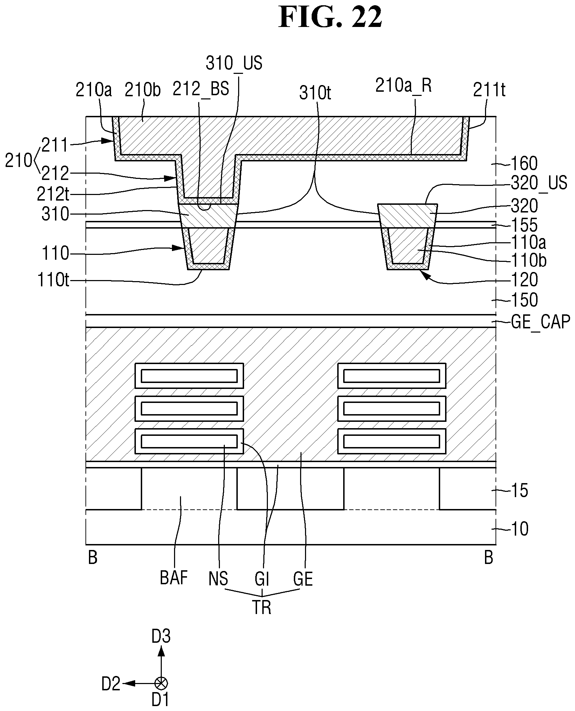

FIG. 22 illustrates a semiconductor device according to some embodiments. For simplicity of description, the following description will focus on differences from the description with reference to FIG. 21.

Referring to FIG. 22, in a semiconductor device according to some embodiments, the transistor TR includes a nanosheet NS, a first gate electrode GE that surrounds the nanosheet NS, and a first gate insulating layer GI between the nanosheet NS and the first gate electrode GE.

The nanosheet NS is disposed on a lower fin-shaped pattern BAF. The nanosheet NS is spaced apart from the lower fin-shaped pattern BAF in the third direction D3. Although the transistor TR is shown as including three nanosheets NS spaced apart in the third direction D3, embodiments of the present disclosure are not limited thereto. In other embodiments, the number of nanosheets NS disposed on the lower fin-shaped pattern BAF in the third direction D3 may be greater than or less than three.

Each of the lower fin-shaped pattern BAF and the nanosheet NS includes, for example, silicon or germanium, which are elemental semiconductor materials. Each of the lower fin-shaped pattern BAF and the nanosheet NS includes a compound semiconductor, such as a group IV-IV compound semiconductor or a group III-V compound semiconductor. The lower fin-shaped pattern BAF and the nanosheet NS may include the same material or different materials.

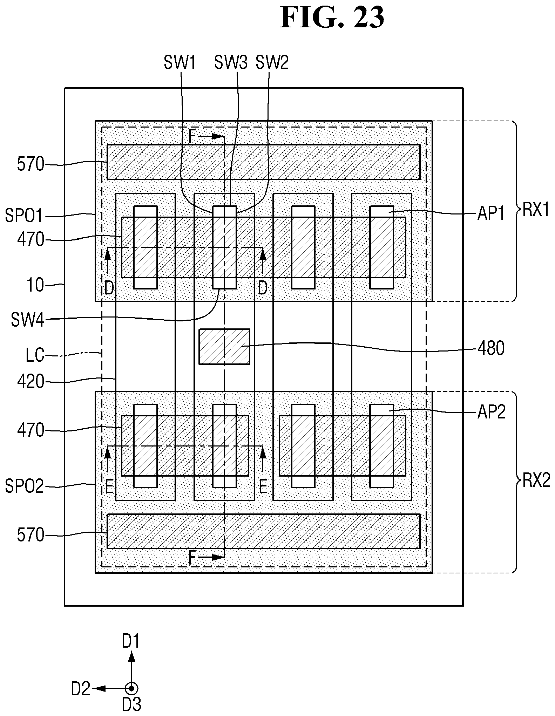

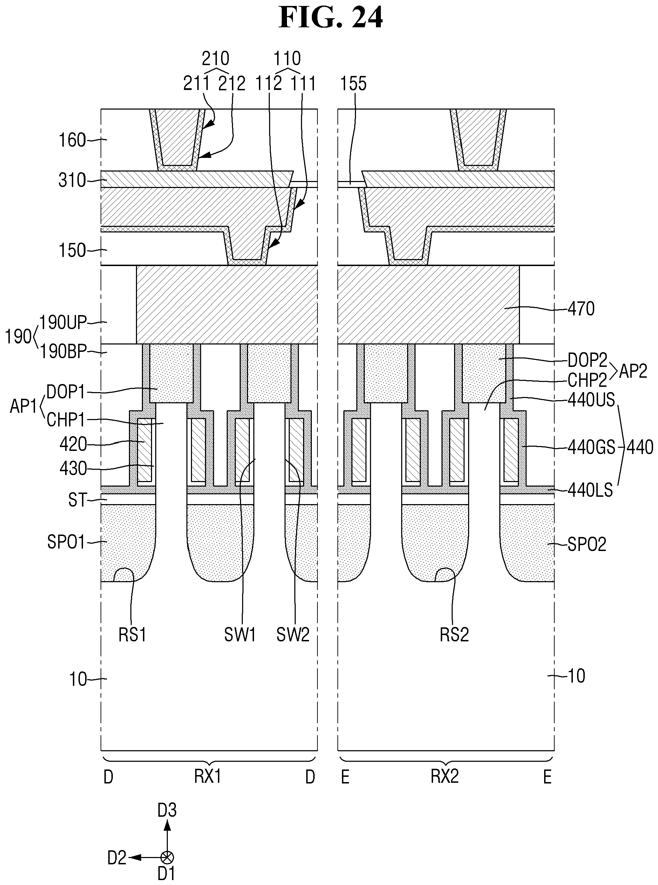

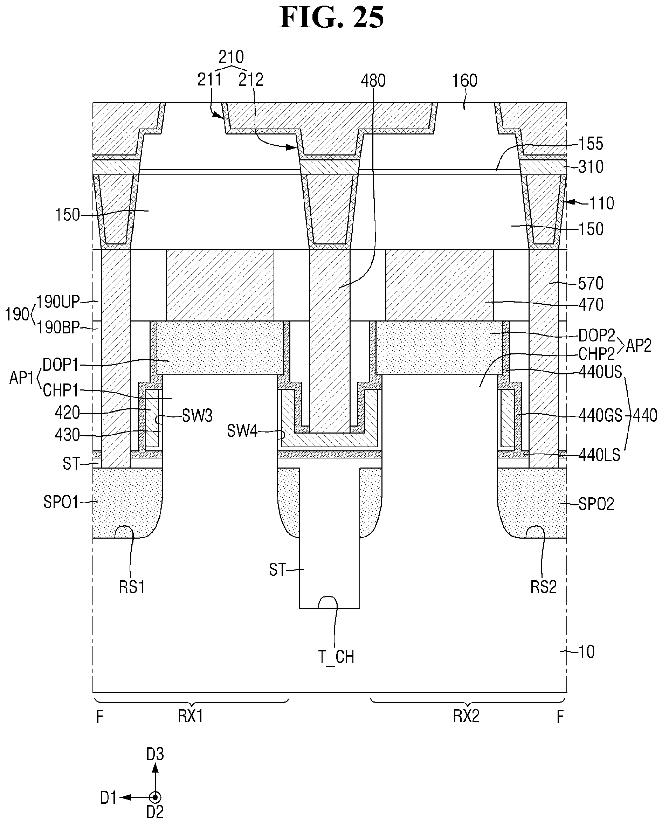

FIGS. 23 to 25 illustrate a semiconductor device according to some embodiments. For reference, FIG. 23 is a plan view of a semiconductor device according to some embodiments. FIG. 24 is a cross-sectional view taken along lines D-D and E-E of FIG. 23. FIG. 25 is a cross-sectional view taken along line F-F of FIG. 23.

Referring to FIGS. 23 to 25, a logic cell LC is disposed on the substrate 10. The logic cell LC may be a logic element, such as an inverter, a flip-flop, etc., that performs a specific function. The logic cell LC includes vertical transistors that constitute a logic element and wires that connect the vertical transistors to each other.

The logic cell LC on the substrate 10 includes a first active region RX1 and a second active region RX2. For example, the first active region RX1 is a PMOSFET region, and the second active region RX2 is an NMOSFET region. The first and second active regions RX1 and RX2 are separated by a trench T_CH formed on the substrate 10. The first and second active regions RX1 and RX2 are spaced apart from each other in the first direction D1.

A first lower epitaxial pattern SPO1 is disposed on the first active region RX1, and a second lower epitaxial pattern SPO2 is disposed on the second active region RX2. In a plan view, the first lower epitaxial pattern SPO1 overlaps the first active region RX1, and the second lower epitaxial pattern SPO2 overlaps the second active region RX2. The first and second lower epitaxial patterns SPO1 and SPO2 are formed by a selective epitaxial growth process. The first lower epitaxial pattern SPO1 is formed in a first recess area RS1 of the substrate 10, and the second lower epitaxial pattern SPO2 is formed in a second recess area RS2 of the substrate 10.

First active patterns AP1 are disposed on the first active region RX1, and second active patterns AP2 are disposed on the second active region RX2. Each of the first and second active patterns AP1 and AP2 has a vertically protruding fin shape. In a plan view, each of the first and second active patterns AP1 and AP2 has a bar shape that extends in the first direction D1. The first active patterns AP1 are spaced apart in the second direction D2, and the second active patterns AP2 are spaced apart the second direction D2.

Each of the first active patterns AP1 includes a first channel pattern CHP1 that vertically protrudes from the first lower epitaxial pattern SPO1 and a first upper epitaxial pattern DOP1 formed on the first channel pattern CHP1. Each of the second active patterns AP2 includes a second channel pattern CHP2 that vertically protrudes from the second lower epitaxial pattern SPO2 and a second upper epitaxial pattern DOP2 formed on the second channel pattern CHP2.

An element isolation layer ST is provided on the substrate 10 and that fills the trench T_CH. The element isolation layer ST covers the upper surfaces of the first and second lower epitaxial patterns SPO1 and SPO2. The first and second active patterns AP1 and AP2 vertically protrude above the element isolation layer ST.

A plurality of second gate electrodes 420 that extend parallel to each other in the first direction D1 are disposed on the element isolation layer ST. The second gate electrodes 420 are spaced apart in the second direction D2. The second gate electrode 420 surrounds the first channel pattern CHP1 of the first active pattern AP1 and surrounds the second channel pattern CHP2 of the second active pattern AP2. For example, the first channel pattern CHP1 of the first active pattern AP1 has first to fourth sidewalls SW1 to SW4. The first and second sidewalls SW1 and SW2 face each other in the second direction D2, and the third and fourth sidewalls SW3 and SW4 face each other in the first direction D1. The second gate electrode 420 is formed on the first to fourth sidewalls SW1 to SW4. In other words, the second gate electrode 420 surrounds the first to fourth sidewalls SW1 to SW4.

A second gate insulating layer 430 is interposed between the second gate electrode 420 and each of the first and second channel patterns CHP1 and CHP2. The second gate insulating layer 430 covers the bottom surface of the second gate electrode 420 and the inner wall of the second gate electrode 420. For example, the second gate insulating layer 430 directly covers the first to fourth sidewalls SW1 to SW4 of the first active pattern AP1.

The first and second upper epitaxial patterns DOP1 and DOP2 vertically protrude above the second gate electrode 420. The upper surface of the second gate electrode 420 is lower than the bottom surface of each of the first and second upper epitaxial patterns DOP1 and DOP2. In other words, each of the first and second active patterns AP 1 and AP2 has a structure that vertically protrudes from the substrate 10 and penetrates the second gate electrode 420.

A semiconductor device according to some embodiments includes vertical transistors in which carriers move in the third direction D3. For example, when a voltage is applied to the second gate electrode 420 to turn on the transistor, carriers move from the lower epitaxial patterns SPO1 and SPO2 to the upper epitaxial patterns DOP1 and DOP2 through the channel patterns CHP1 and CHP2. In a semiconductor device according to some embodiments, the second gate electrode 420 completely surrounds the sidewalls SW1 to SW4 of the channel patterns CHP1 and CHP2. A transistor according to some embodiments of the present disclosure is a three-dimensional field effect transistor, e.g., VFET, that has a gate all around structure. Since the gate surrounds the channel, a semiconductor device according to some embodiments has excellent electrical characteristics.

A spacer 440 that covers the second gate electrodes 420 and the first and second active patterns AP 1 and AP2 is disposed on the element isolation layer ST. The spacer 440 includes a silicon nitride layer or a silicon oxynitride layer. The spacer 440 includes a lower spacer 440LS, an upper spacer 440US, and a gate spacer 440GS between the lower and upper spacers 440LS and 440US.

The lower spacer 440LS directly covers the upper surface of the element isolation layer ST. The second gate electrodes 420 are spaced apart from the element isolation layer ST in the third direction D3 by the lower spacer 440LS. The gate spacer 440GS covers the upper surface and the outer wall of each of the second gate electrodes 420. The upper spacer 440 covers the first and second upper epitaxial patterns DOP1 and DOP2. However, the upper spacer 440US does not cover the upper surfaces of the first and second upper epitaxial patterns DOP1 and DOP2, but exposes the upper surfaces of the first and second upper epitaxial patterns DOP1 and DOP2.

A first portion 190BP of a lower interlayer insulating layer 190 is disposed on the spacer 440. The upper surface of the first portion 190BP of the lower interlayer insulating layer 190 is substantially coplanar with the upper surfaces of the first and second upper epitaxial patterns DOP1 and DOP2. A second portion 190UP of the lower interlayer insulating layer 190 and the first and second interlayer insulating layers 150 and 160 are sequentially stacked on the first portion 190BP of the lower interlayer insulating layer 190. The first portion 190BP of the lower interlayer insulating layer 190 and the second portion 190UP of the lower interlayer insulating layer 190 are included in the lower interlayer insulating layer 190. The second portion 190UP of the lower interlayer insulating layer 190 covers the upper surfaces of the first and second upper epitaxial patterns DOP1 and DOP2.

At least one first source/drain contact 470 is provided that penetrates the second portion 190UP of the lower interlayer insulating layer 190 and connects to the first and second upper epitaxial patterns DOP1 and DOP2. At least one second source/drain contact 570 is provided that sequentially penetrates the lower interlayer insulating layer 190, the lower spacer 440LS, and the element isolation layer ST and connects to the first and second lower epitaxial patterns SPO1 and SPO2. A gate contact 480 is provided that sequentially penetrates the second portion 190UP of the lower interlayer insulating layer, the first portion 190BP of the lower interlayer insulating layer, and the gate spacer 440GS and connects to the second gate electrode 420.

In addition, an etch stop layer is additionally disposed between the second portion 190UP of the lower interlayer insulating layer and the first interlayer insulating layer 150. A first etch stop layer 155 is disposed between the first interlayer insulating layer 150 and the second interlayer insulating layer 160.

The first conductive lower wiring 110 is disposed in the first interlayer insulating layer 150. The first conductive lower wiring 110 includes a via part 112 and a wiring part 111. The first conductive lower wiring 110 is connected to the first source/drain contact 470, the second source/drain contact 570, and the gate contact 480. A first upper wiring structure 210 and a first conductive insertion pattern 310 are disposed in the second interlayer insulating layer 160.

In addition, a conductive insertion pattern is further disposed between the first source/drain contact 470 and the first conductive lower wiring 110. In addition, a conductive insertion pattern is further disposed between the second source/drain contact 570 and the first conductive lower wiring 110. A conductive insertion pattern is further disposed between the gate contact 480 and the first conductive lower wiring 110.

Unlike the illustrated example, in an embodiment, an additional wiring structure similar to the first upper wiring structure 210 is further disposed between the first source/drain contact 470 and the first conductive lower wiring 110.

Detailed descriptions of the first conductive lower wiring 110, the first conductive insertion pattern 310, and the first upper wiring structure 210 are substantially the same as those described with reference to FIGS. 1 to 20.

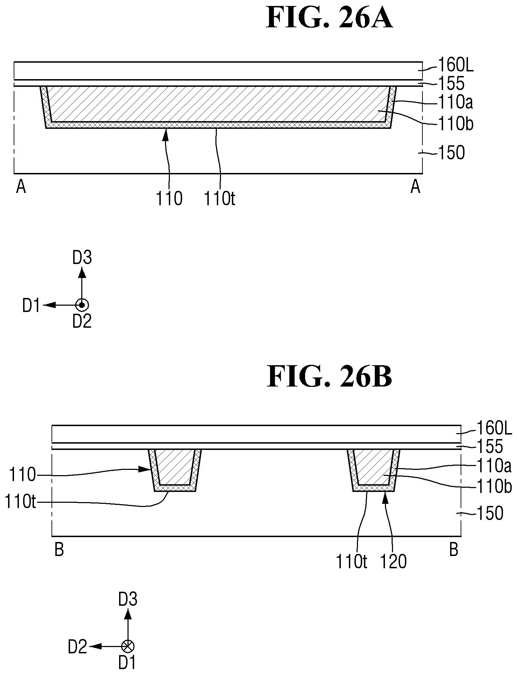

FIGS. 26A to 29B illustrate intermediate steps of a method for fabricating a semiconductor device according to some embodiments. For reference, FIGS. 26A, 27A, 28A, and 29A are cross-sectional views taken along line A-A of FIG. 1, respectively. FIGS. 26B, 27B, 28B, and 29B are cross-sectional views taken along line B-B of FIG. 1, respectively.

Referring to FIGS. 26A and 26B, the first conductive lower wiring 110 and the second conductive lower wiring 120 are formed in the first interlayer insulating layer 150.

The lower wiring trenches 110t are formed in the first interlayer insulating layer 150. The first conductive lower wiring 110 and the second conductive lower wiring 120 are formed in the lower wiring trenches 110t. The first conductive lower wiring 110 and the second conductive lower wiring 120 include a lower wiring barrier layer 110a and a lower wiring filling layer 110b, respectively.

Subsequently, the first etch stop layer 155 is formed on the first interlayer insulating layer 150, the first conductive lower wiring 110, and the second conductive lower wiring 120. Also, a second lower interlayer insulating layer 160L is formed on the first etch stop layer 155.

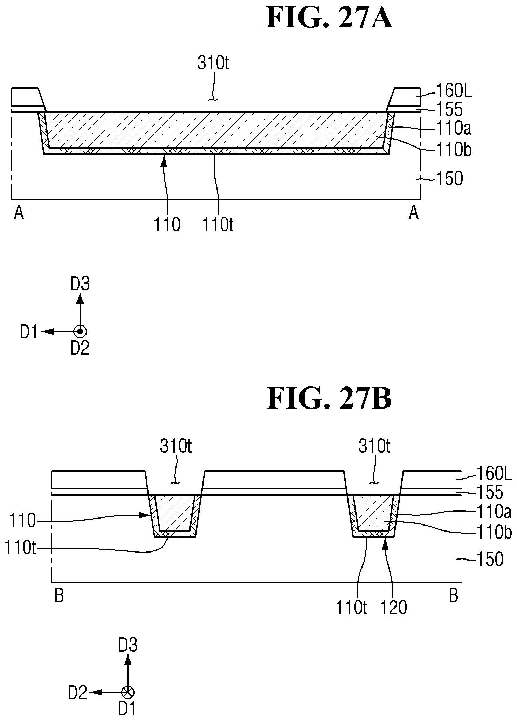

Referring to FIGS. 27A and 27B, the insertion pattern trenches 310t are formed in the second lower interlayer insulating layer 160L.

The second lower interlayer insulating layer 160L, which includes the insertion pattern trench 310t, is formed on the first conductive lower wiring 110 and the second conductive lower wiring 120.

The insertion pattern trenches 310t penetrate through the first etch stop layer 155. The insertion pattern trenches 310t expose the first conductive lower wiring 110 and the second conductive lower wiring 120. One insertion pattern trench 310t exposes one conductive lower wiring 110, 120.

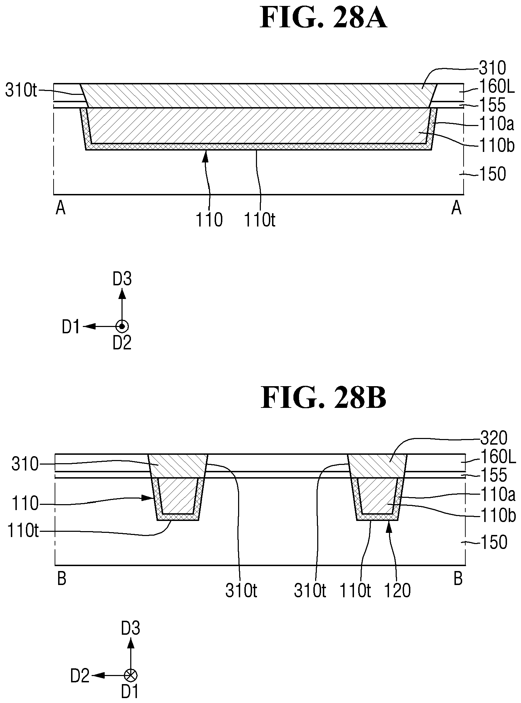

Referring to FIGS. 28A and 28B, the first conductive insertion pattern 310 and the second conductive insertion pattern 320 are formed on the first conductive lower wiring 110 and the second conductive lower wiring 120, respectively.

Each of the first conductive insertion pattern 310 and the second conductive insertion pattern 320 fills the insertion pattern trench 310t.

The first conductive insertion pattern 310 is connected to the first conductive lower wiring 110, and the second conductive insertion pattern 320 is connected to the second conductive lower wiring.

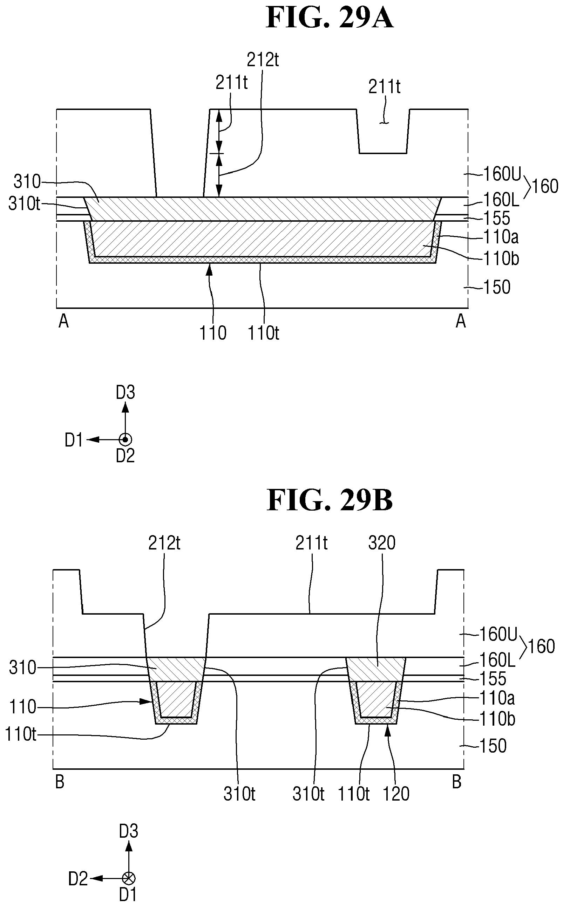

Referring to FIGS. 29A and 29B, the second upper interlayer insulating layer 160U is formed on the first conductive insertion pattern 310 and the second conductive insertion pattern 320.

The second upper interlayer insulating layer 160U includes upper wiring trenches 211t and upper via holes 212t. The upper via holes 212t are formed on the bottom surface of the upper wiring trenches 211t. The upper via holes 212t expose the first conductive insertion pattern 310 and the second conductive insertion pattern 320.

Subsequently, referring to FIGS. 1 to 4, the first upper wiring structure 210 and the second upper wiring structure 220 are formed in the upper wiring trenches 211t and the upper via holes 212t. The first upper wiring structure 210 and the second upper wiring structure 220 fill the upper wiring trenches 211t and the upper via holes 212t.

## Claims

1. A semiconductor device, comprising:
a first conductive lower wiring (110) disposed at a first metal level and that extends in a first direction;
a first upper wiring structure (210) connected to the first conductive lower wiring (110) and that includes a first conductive upper wiring (211) and a first conductive upper via (212), wherein the first conductive upper wiring (211) is disposed at a second metal level higher than the first metal level and extends in a second direction different from the first direction; and
a conductive insertion pattern (310, 320) extending along an upper surface of the first conductive lower wiring (110) and disposed between the first conductive lower wiring (110) and the first upper wiring structure (210) and connected to the first conductive upper via (212),
wherein an upper surface (310_US, 320_US) of the conductive insertion pattern (310, 320) has a first width in the first direction, and
a bottom surface (212_BS) of the first conductive upper via (212) has a second width in the first direction that is less than the first width,
further comprising an etch stop layer (155) disposed on the first conductive lower wiring (110),
wherein a thickness of the conductive insertion pattern (310, 320) is greater than a thickness of the etch stop layer (155), and **characterized in that** the conductive insertion pattern (310, 320) is disposed in an interlayer insulating layer (160) which is disposed on the etch stop layer (155).

2. The semiconductor device of claim 1, wherein the upper surface (310_US, 320_US) of the conductive insertion pattern (310, 320) has a third width in the second direction, and the bottom surface (212_BS) of the first conductive upper via (212) has a fourth width in the second direction that is less than the third width.

3. The semiconductor device of claim 1, wherein the upper surface (310_US, 320_US) of the conductive insertion pattern (310, 320) and the bottom surface (212_BS) of the first conductive upper via (212) each have a third width in the second direction.

4. The semiconductor device of claim 1, wherein the conductive insertion pattern (310, 320) is in contact with the first conductive lower wiring (110) and the first conductive upper via (212).

5. The semiconductor device of claim 1, wherein a thickness of the conductive insertion pattern (310, 320) is less than a thickness of the first conductive lower wiring (110) and a thickness of the first conductive upper wiring (211).

6. The semiconductor device of claim 1, further comprising:
a second conductive lower wiring (120) disposed at the first metal level and that extends in the first direction; and
a second upper wiring structure (220) connected to the second conductive lower wiring (120) and that includes a second conductive upper wiring (221) and a second conductive upper via (222),
wherein the second conductive upper wiring (221) extends in the second direction at the second metal level, and
the second conductive upper via (222) is directly connected to the second conductive lower wiring (120).

7. The semiconductor device of claim 1, wherein the conductive insertion pattern (310, 320) has a single layer structure.

8. The semiconductor device of claim 1, wherein the first upper wiring structure (210) includes a barrier conductive layer and a filling conductive layer disposed on the barrier conductive layer,
the filling conductive layer fills a recess formed in the barrier conductive layer, and
each of the first conductive upper wiring (211) and the first conductive upper via (212) includes the barrier conductive layer and the filling conductive layer.

9. The semiconductor device of claim 1, comprising:
the conductive insertion pattern (310, 320) directly connected to the first conductive upper via (212) and the first conductive lower wiring (110),
wherein in a plan view, an area of the upper surface (310_US, 320_US) of the conductive insertion pattern (310, 320) is greater than an area of a bottom surface (212_BS) of the first conductive upper via (212) .

10. The semiconductor device of claim 9, wherein the upper surface (310_US, 320_US) of the conductive insertion pattern (310, 320) has a first width in the second direction, and
a bottom surface (212_BS) of the first conductive upper via (212) has a second width in the second direction that is less than the first width.

11. The semiconductor device of claim 9, wherein the conductive insertion pattern (310, 320) includes a barrier conductive layer and a filling conductive layer disposed on the barrier conductive layer.

## Patentansprüche

1. Halbleitervorrichtung, die folgendes aufweist:
eine erste leitende untere Verdrahtung (110), die auf einem ersten Metalllevel angeordnet ist und sich in eine erste Richtung erstreckt;
eine erste obere Verdrahtungsstruktur (210), die mit der ersten leitenden unteren Verdrahtung (110) verbunden ist und die eine erste leitende obere Verdrahtung (211) und ein erstes leitendes oberes Via (212) enthält, wobei die erste leitende obere Verdrahtung (211) auf einem zweiten Metalllevel angeordnet ist, das höher als das erste Metalllevel ist, und sich in einer zweiten Richtung erstreckt, die sich von der ersten Richtung unterscheidet; und
ein leitendes Einfügemuster (310, 320), das sich entlang einer oberen Fläche der ersten leitenden unteren Verdrahtung (110) erstreckt und zwischen der ersten leitenden unteren Verdrahtung (110) und der ersten oberen Verdrahtungsstruktur (210) angeordnet ist und mit dem ersten leitenden oberen Via (212) verbunden ist,
wobei eine obere Fläche (310_US, 320_US) des leitenden Einfügemusters (310, 320) eine erste Breite in der ersten Richtung hat, und
eine untere Fläche (212_BS) des ersten leitenden oberen Vias (212) eine zweite Breite in der ersten Richtung hat, die geringer ist als die erste Breite,
ferner aufweisend eine Ätzstoppschicht (155), die auf der ersten leitenden unteren Verdrahtung (110) angeordnet ist,
wobei eine Dicke des leitenden Einfügemusters (310, 320) größer ist als eine Dicke der Ätzstoppschicht (155), und **dadurch gekennzeichnet, dass**
das leitende Einfügemuster (310, 320) in einer Zwischenschicht-Isolierschicht (160) angeordnet ist, die auf der Ätzstoppschicht (155) angeordnet ist.

2. Halbleitervorrichtung nach Anspruch 1, wobei die obere Fläche (310_US, 320_US) des leitenden Einfügemusters (310, 320) eine dritte Breite in der zweiten Richtung hat, und
die untere Fläche (212_BS) des ersten leitenden oberen Vias (212) eine vierte Breite in der zweiten Richtung hat, die geringer ist als die dritte Breite.

3. Halbleitervorrichtung nach Anspruch 1, wobei die obere Fläche (310_US, 320_US) des leitenden Einfügemusters (310, 320) und die untere Fläche (212_BS) des ersten leitenden oberen Vias (212) jeweils eine dritte Breite in der zweiten Richtung haben.

4. Halbleitervorrichtung nach Anspruch 1, wobei das leitende Einfügemuster (310, 320) in Kontakt mit der ersten leitenden unteren Verdrahtung (110) und dem ersten leitenden oberen Via (212) steht.

5. Halbleitervorrichtung nach Anspruch 1, wobei die Dicke des leitenden Einfügemusters (310, 320) geringer ist als die Dicke der ersten leitenden unteren Verdrahtung (110) und die Dicke der ersten leitenden oberen Verdrahtung (211).

6. Halbleitervorrichtung nach Anspruch 1, ferner aufweisend:
eine zweite leitende untere Verdrahtung (120), die auf dem ersten Metalllevel angeordnet ist und sich in der ersten Richtung erstreckt; und
eine zweite obere Verdrahtungsstruktur (220), die mit der zweiten leitenden unteren Verdrahtung (120) verbunden ist und die eine zweite leitende obere Verdrahtung (221) und ein zweites leitendes oberes Via (222) enthält,
wobei sich die zweite leitende obere Verdrahtung (221) in der zweiten Richtung auf der zweiten Metallebene erstreckt, und
das zweite leitende obere Via (222) direkt mit der zweiten leitenden unteren Verdrahtung (120) verbunden ist.

7. Halbleitervorrichtung nach Anspruch 1, wobei das leitende Einfügemuster (310, 320) eine einschichtige Struktur hat.

8. Halbleitervorrichtung nach Anspruch 1, wobei die erste obere Verdrahtungsstruktur (210) eine leitende Barriereschicht und eine leitende Füllschicht enthält, die auf der leitenden Barriereschicht angeordnet ist,
die leitende Füllschicht eine in der leitenden Barriereschicht gebildete Vertiefung füllt, und
die erste leitende obere Verdrahtung (211) und das erste leitende obere Via (212) jeweils die leitende Barriereschicht und die leitende Füllschicht enthalten.

9. Halbleitervorrichtung nach Anspruch 1, aufweisend:
das leitende Einfügemuster (310, 320), das direkt mit dem ersten leitenden oberen Via (212) und der ersten leitenden unteren Verdrahtung (110) verbunden ist,
wobei in einer Draufsicht ein Bereich der oberen Fläche (310_US, 320_US) des leitenden Einfügemusters (310, 320) größer ist als ein Bereich einer unteren Fläche (212_BS) des ersten leitenden oberen Vias (212).

10. Halbleitervorrichtung nach Anspruch 9, wobei die obere Fläche (310_US, 320_US) des leitenden Einfügemusters (310, 320) eine erste Breite in der zweiten Richtung hat, und eine untere Fläche (212_BS) des ersten leitenden oberen Vias (212) eine zweite Breite in der zweiten Richtung hat, die geringer ist als die erste Breite.

11. Halbleitervorrichtung nach Anspruch 9, wobei das leitende Einfügemuster (310, 320) eine leitende Barriereschicht und eine auf der leitenden Barriereschicht angeordnete leitende Füllschicht enthält.

## Revendications

1. Dispositif semi-conducteur comprenant:
un premier câblage conducteur inférieur (110) disposé à un premier niveau métallique et qui s'étend dans une première direction;
une première structure de câblage supérieure (210) connectée au premier câblage conducteur inférieur (110) et qui comprend un premier câblage conducteur supérieur (211) et un premier via conducteur supérieur (212), dans lequel le premier câblage conducteur supérieur (211) est disposé à un deuxième niveau métallique supérieur au premier niveau métallique et s'étend dans une deuxième direction différente de la première direction; et
un motif d'insertion conducteur (310, 320) s'étendant le long d'une surface supérieure du premier câblage conducteur inférieur (110) et disposé entre le premier câblage conducteur inférieur (110) et la première structure de câblage supérieure (210) et connecté au premier via conducteur supérieur (212),
dans lequel une surface supérieure (310_US, 320_US) du motif d'insertion conducteur (310, 320) présente une première largeur dans la première direction, et
une surface inférieure (212_BS) du premier via supérieur conducteur (212) présente une deuxième largeur dans la première direction qui est inférieure à la première largeur,
comprenant en outre une couche d'arrêt de gravure (155) disposée sur le premier câblage conducteur inférieur (110),
dans lequel une épaisseur du motif d'insertion conducteur (310, 320) est supérieure à une épaisseur de la couche d'arrêt de gravure (155), et **caractérisé en ce que**
le motif d'insertion conducteur (310, 320) est disposé dans une couche isolante intercouche (160) qui est disposée sur la couche d'arrêt de gravure (155).

2. Dispositif semi-conducteur de la revendication 1, dans lequel la surface supérieure (310_US, 320_US) du motif d'insertion conducteur (310, 320) présente une troisième largeur dans la deuxième direction, et
la surface inférieure (212_BS) du premier via supérieur conducteur (212) présente une quatrième largeur dans la deuxième direction qui est inférieure à la troisième largeur.

3. Dispositif semi-conducteur de la revendication 1, dans lequel la surface supérieure (310_US, 320_US) du motif d'insertion conducteur (310, 320) et la surface inférieure (212_BS) du premier via supérieur conducteur (212) présentent chacune une troisième largeur dans la deuxième direction.

4. Dispositif semi-conducteur de la revendication 1, dans lequel le motif d'insertion conducteur (310, 320) est en contact avec le premier câblage conducteur inférieur (110) et le premier via conducteur supérieur (212).

5. Dispositif semi-conducteur de la revendication 1, dans lequel une épaisseur du motif d'insertion conducteur (310, 320) est inférieure à une épaisseur du premier câblage conducteur inférieur (110) et à une épaisseur du premier câblage conducteur supérieur (211).

6. Dispositif semi-conducteur de la revendication 1, comprenant en outre:
un deuxième câblage conducteur inférieur (120) disposé au premier niveau métallique et qui s'étend dans la première direction; et
une deuxième structure de câblage supérieure (220) connectée au deuxième câblage conducteur inférieur (120) et qui comprend un deuxième câblage conducteur supérieur (221) et un deuxième via conducteur supérieur (222),
dans lequel le deuxième câblage supérieur conducteur (221) s'étend dans la deuxième direction au deuxième niveau métallique, et
le deuxième via supérieur conducteur (222) est directement connecté au deuxième câblage conducteur inférieur (120).

7. Dispositif semi-conducteur de la revendication 1, dans lequel le motif d'insertion conducteur (310, 320) présente une structure à couche unique.

8. Dispositif semi-conducteur de la revendication 1, dans lequel la première structure de câblage supérieure (210) comprend une couche conductrice de barrière et une couche conductrice de remplissage disposée sur la couche conductrice de barrière,
la couche conductrice de remplissage remplit une cavité formée dans la couche conductrice de barrière, et
le premier câblage supérieur conducteur (211) et le premier via supérieur conducteur (212) comprennent chacun la couche conductrice de barrière et la couche conductrice de remplissage.

9. Dispositif semi-conducteur de la revendication 1, comprenant:
le motif d'insertion conducteur (310, 320) directement connecté au premier via supérieur conducteur (212) et au premier câblage inférieur conducteur (110),
dans lequel, dans une vue en plan, une partie de la surface supérieure (310_US, 320_US) du motif d'insertion conducteur (310, 320) est supérieure à une partie d'une surface inférieure (212_BS) du premier via supérieur conducteur (212).

10. Dispositif semi-conducteur de la revendication 9, dans lequel la surface supérieure (310_US, 320_US) du motif d'insertion conducteur (310, 320) présente une première largeur dans la deuxième direction, et
une surface inférieure (212_BS) du premier via supérieur conducteur (212) présente une deuxième largeur dans la deuxième direction qui est inférieure à la première largeur.

11. Dispositif semi-conducteur de la revendication 9, dans lequel le motif d'insertion conducteur (310, 320) comprend une couche conductrice de barrière et une couche conductrice de remplissage disposée sur la couche conductrice de barrière.
